# EUROPÄISCHE PATENTSCHRIFT

(11) **EP 3 710 223 B1**
(45) Veröffentlichungstag und Bekanntmachung des Hinweises auf die Patenterteilung: **21.04.2021**
(21) Anmeldenummer: 19773399.1
(22) Anmeldetag: 19.09.2019
(51) Int. Cl.: B29C 45/76, G06F 30/20

(54) **VERFAHREN ZUR STEUERUNG EINER MASCHINE ZUR VERARBEITUNG VON KUNSTSTOFFEN**
METHOD FOR CONTROLLING A MACHINE FOR PROCESSING PLASTICS
PROCÉDÉ DE COMMANDE D'UNE MACHINE DE TRAITEMENT DE MATIÈRES PLASTIQUES

(30) Priorität: 23.09.2018 DE 102018123361
(43) Veröffentlichungstag der Anmeldung: 23.09.2020
(73) Patentinhaber: Arburg GmbH + Co KG, 72290 Loßburg (DE)
(72) Erfinder: DUFFNER, Eberhard, 72181 Starzach (DE); KRAIBÜHLER, Herbert, 72290 Loßburg (DE)
(74) Vertreter: RPK Patentanwälte Reinhardt, Pohlmann und Kaufmann Partnerschaft mbB
(86) Internationale Anmeldenummer: PCT/EP2019/075142
(87) Internationale Veröffentlichungsnummer: WO 2020/058387

(56) Entgegenhaltungen:
- EP-A1- 0 698 467
- DE-B3-102015 107 024
- DE-B3-102015 117 237
- JP-A- H 081 744
- JP-A- H11 232 250
- US-A1- 2004 256 755
- US-A1- 2017 001 356

## Beschreibung

Die Erfindung betrifft ein Verfahren zur Steuerung einer Maschine zur Verarbeitung von Kunststoffen und anderer plastifizierbarer Massen, wie keramische oder pulverige Massen nach dem Oberbegriff des Anspruches 1.

Um einen Spritzgießprozess erfolgreich durchzuführen, benötigt es neben einer entsprechenden Hardware auch weitreichendes Wissen über den Spritzgießprozess bzw. wie der Spritzgießprozess für das gewünschte Spritzteil ausgeführt werden soll, damit eine möglichst gute Qualität innerhalb einer effizienten Zykluszeit erzielt werden kann. Oft sind dafür viele komplexe Einstellungen an der Spritzgießmaschine selbst, am Werkzeug, an der Peripherie oder an der Maschinensteuerung vorzunehmen, was mit einem erheblichen Aufwand verbunden ist und zu Fehlern führen kann. Zudem basieren solche Einstellungen oft auf Erfahrungswerten, sodass die komplexe Steuerung und Einstellung des Spritzgießprozesses meist nur fachkundigen Bedienern vorbehalten bleibt, welche diese Einstellungen aus ihrem Fach- und Erfahrungswissen vornehmen können. Sonst müssen die Einstellungen mit Hilfe eines aufwändigen und zeitintensiven "Trial-and-Error-Prozesses" gefunden werden.

Aus der dem Oberbegriff des Anspruchs 1 zugrunde liegenden WO 2014/183863 A1 ist ein Verfahren zum Betreiben einer Maschine zur Verarbeitung von Kunststoffen bekannt, für das Informationen über eine Bauteilgestaltung für ein Spritzteil an die Steuerung der Maschine bereitgestellt und Anlagen- und Prozessparameter durch die Steuerung zur Herstellung des Spritzteils berechnet werden. Mit Hilfe mehrerer Assistenten hinsichtlich Qualität, Spritzgießform und Formteil wird geprüft, ob das gewünschte Spritzteil mit den berechneten Anlagen- und Prozessparametern herstellbar ist. Ist das Spritzteil so nicht herstellbar, wird dies dem Bediener angezeigt und dieser aufgefordert, weitere Informationen anzugeben.

Aus der AT 513481 A4 sind eine Simulationsvorrichtung sowie ein Verfahren bekannt, bei denen in einer Maschinensimulation eine Spritzgießmaschine nachgebildet wird und ein erster Parameter berechnet wird, welcher einer Prozesssimulation zur Nachbildung eines Spritzgießmaterials und/oder eines Spritzgießwerkzeugs mitgeteilt wird. Dadurch wird versucht, das fertige Produkt des Spritzgießprozesses vorauszuberechnen. Für das Ergebnis des Spritzgießprozesses werden wesentliche Elemente des Prozesses simuliert und die Ergebnisse der Simulationen ausgetauscht, um dadurch eine Vorausberechnung des fertigen Produkts durchzuführen.

Ein Verfahren zur Simulation einer fiktiven Konfiguration einer Formgebungsanlage ist in der DE 10 2015 015 811 A1 offenbart. Ein bei Betrieb der Formgebungsanlage gemessener ausgelesener Prozesswert wird als Eingabeparameter für ein die fiktive Konfiguration der Formgebungsanlage repräsentierendes Modell verwendet. So kann bereits im Vorfeld geklärt werden, ob eine Änderung der bestehenden Formgebungsanlage hinsichtlich einer optionalen Ausrüstung sich im Einzelfall rechnet. Es wird also die komplette Formgebungsanlage simuliert bzw. deren Verhalten simuliert bei einer Änderung z.B. der Peripherie.

Aus der DE 692 15 634 T2 ist ein Verfahren zum Überwachen des Einspritzdrucks einer Spritzgießmaschine während eines Spritzgießprozesses bekannt. Vorab werden Hohlraumdaten der Gießform gespeichert und diese in einem anschließenden Schritt in unterteilten Bereichen angezeigt. In einem nächsten Schritt wird die Schneckenposition erfasst und ein Diagramm mit einer Beziehung zwischen erfasster Schneckenposition und Einspritzdruck angezeigt. Der Schneckenpositionsbereich, welcher den unterteilten Bereichen des Hohlraums entspricht, welcher mit Kunstharz gefüllt ist, wird zudem angezeigt, wodurch ersichtlich ist, welche Schneckenposition bei welchem Füllstand des Hohlraums gegeben ist.

Ein Verfahren zum Überwachen einer Harzposition in einem Forminnenraum während eines Spritzgießprozesses ist in der DE 692 18 317 T2 offenbart. Der Forminnenraum wird dabei in eine Vielzahl von Bereichen mit Grenzabschnitten unterteilt. Danach werden Volumina auf diese unterteilten Bereiche verteilt und in eine Steuereinheit eingegeben, sodass in einem nächsten Schritt Schneckenpositionen angezeigt werden können, in denen das vordere Ende des Harzes die Grenzabschnitte erreicht.

In der DE 10 2015 107 024 B3 wird eine charakteristische formteilspezifische Drucckurve aus CAD-Daten ermittelt. Auf Basis der Druckkurve werden charakteristische formteilspezifische Ereignisstellen ermittelt. Anschließend erfolgt ein Spritzguss-Prozess, in dem eine Mess-Druckkurve ermittelt wird. Mit Hilfe der Mess-Druckkurve werden ebenfalls Mess-Ereignisstellen ermittelt, welche dann mit den charakteristischen formteilspezifischen Ereignisstellen abgeglichen bzw. entsprechend zugeordnet werden, sodass sich virtuelle Ereignisse ergeben. Aus diesen virtuellen Ereignissen werden dann Prozessparameterwerte abgeleitet.

Während eines Spritzgießprozesses wird in der DE 10 2015 117 237 B3 ein reales Volumen bestimmt, indem zunächst ein theoretisches Volumen und ein Massedruck ermittelt werden. Durch die Auswahl einer dem Massedruck entsprechenden materialspezifischen Kompression lässt sich unter Berücksichtigung dieser das reale Volumen berechnen.

In der JP H11 232250 A wird ein Durchfluss und Druck in einer dreidimensionalen Strömung auf demselben Gitterpunkt ermittelt. Durch das Ersetzen eines halbdiskretisierten Impulsausdrucks erhält man zunächst den Druckausdruck. Zum Ermitteln einer Durchflussrate und eines Drucks wird eine Wiederholungsberechnung ausgeführt, um die Durchflussrate und den Druck auf demselben Gitterpunkt zu ermitteln.

Eigenschaften eines Kunststoffprodukts und eines Aluminiumprodukts werden in der JP H08 1744 A dadurch stabilisiert, dass ein erforderlicher Einspritzzustand durch ein Verfahren realisiert wird. Es wird ein Modell gebildet, bei dem eine Hohlraumform in Mikroelemente unterteilt ist. Hierbei wird eine Fließanalyse unter Verwendung einer numerischen Lösung durchgeführt.

In der US 2004/256755 A1 werden Forminformationen eines Formteils verwendet, um Querschnittsinformationen zu bestimmen. Ein Einspritzgeschwindigkeitsmuster wird basierend auf Parameterinformationen und den erzeugten Querschnittsinformationen erzeugt. Das Einspritzgeschwindigkeitsmuster wird anschließend verwendet, um die Einspritzgeschwindigkeit der Schnecke zu steuern.

In der US 2017/001356 A1 wird die Querschnittsfläche mit einer Software als Funktion des Abstands vom Anguss berechnet. Über die Querschnittsfläche bestimmt die Software ein Schmelzdruckprofil zum Füllen des Formhohlraums bei einem konstanten Fluss.

In der EP 0 698 467 A1 wird ein dreidimensionales Modell in mehrere kleine Elemente einer Kavität unterteilt. Danach wird ein Flusswert K bestimmt, womit Drücke, Druckübergänge oder Strömungsgeschwindigkeiten an den jeweiligen kleinen Elementen anhand der ermittelten Strömungsleitfähigkeiten berechnet werden.

Bei den Lösungen im Stand der Technik werden einerseits entweder das komplette Spritzteil oder andererseits die komplette Formgebungsanlage simuliert, wozu jeweils eine entsprechende Simulations- bzw. Rechenleistung benötigt wird. Ferner müssen bei diesen Lösungen viele verschiedenste Eingaben hinsichtlich der Simulationsparameter vom Bediener vorgenommen werden. Bei einer anschließenden Fertigung des Spritzteils müssen diese aus der Simulation erhaltenen Eingaben dann wieder für den realen Spritzgießprozess übernommen werden.

Ausgehend von diesem Stand der Technik liegt der vorliegenden Erfindung die Aufgabe zugrunde, eine vereinfachte, schnelle und effektive Parametrierung des Spritzgießprozesses zu ermöglichen und so die Einrichtzeit und Qualität des Spritzteils zu verbessern.

Dies wird mit einem Verfahren zur Steuerung einer Maschine zur Verarbeitung von Kunststoffen und anderer plastifizierbarer Materialien wie pulverförmige und/oder keramische Massen gemäß den Merkmalen des Patentanspruches 1 gelöst. Vorteilhafte Weiterbildungen sind Gegenstand der abhängigen Patentansprüche. Die in den Patentansprüchen einzeln aufgeführten Merkmale sind in technologisch sinnvoller Weise miteinander kombinierbar und können durch erläuternde Sachverhalte aus der Beschreibung und durch Details aus den Figuren ergänzt werden, wobei weitere Ausführungsvarianten der Erfindung aufgezeigt werden.

Bei dem erfindungsgemäßen Verfahren geht es um eine Berechnung von möglichst vielen Einstelldaten des Spritzgießprozesses für eine Spritzgießmaschine sowie ihrer Peripherie bzgl. des zu verarbeitenden Materials aus dem bekannten Volumenmodell des Spritzteils. Die Maschine weist eine Formöffnungs- und schließeinheit zum Öffnen und Schließen einer Spritzgießform mit wenigstens einem Formhohlraum zur Herstellung eines der Form des Formhohlraumes entsprechenden Spritzteils, eine Spritzgießeinheit mit Mitteln zum Plastifizieren und zum Einspritzen des plastifizierbaren Materials in den Formhohlraum und eine Maschinensteuerung, die mit einem Expertenwissen verbunden ist und bedarfsweise über einen interaktiven Kontakt vom Bediener bedienbar ist, z.B. über eine Anzeige-/Bedienvorrichtung. Die Anzeige-/Bedienvorrichtung ist beispielsweise als interaktive Eingabemöglichkeit mit einem Bildschirm ausgestaltet z.B. als Multitouchscreen und steht in Verbindung mit der Maschinensteuerung. Das Expertenwissen kann beispielswiese in Form von Datenbanken und/oder Datenspeichern vorliegen, welche z.B. über ein Netzwerk mit der Maschinensteuerung verbunden sind.

Das Expertenwissen beinhaltet z.B. Daten über Werkstoffe, wie z.B. die spezifische Dichte des festen und flüssigen Materials, die Schmelztemperatur, den Fließindex, die maximale Scherrate und/oder allgemein das Druck-Temperatur-Verhalten beim Abkühlen der Materialien von flüssig nach fest. Es können jedoch auch weitere Daten bezüglich der zu verarbeitenden Werkstoffe enthalten sein.

Eine weitere Datenbank betrifft z.B. Daten für die Ausführung des Verfahrens und ist aus dem Spritzgießwissen bezüglich charakteristischer Prozessverläufe aufgebaut. Ein Beispiel hierfür sind Daten für die Füllzeit für bestimmte Werkzeugklassen, bestimmte Fließweg-Wandstärken-Verhältnisse im Spritzteil zusammen mit bestimmten Werkstoffklassen sowie Nachdruckhöhen bezogen auf minimale und maximale Wandstärken am Spritzteil.

Eine weitere Datenbank enthält beispielsweise das Wissen der Maschinensteuerung zu den statischen und dynamischen Eigenschaften der eigenen Maschinenkinematik.

Für das erfindungsgemäße Verfahren werden Informationen über die Geometrie des Spritzteils und/oder des Formhohlraumes und des Angusspunktes an die Maschinensteuerung bereitgestellt. Diese Informationen können beispielsweise vom Bediener direkt in die Maschinensteuerung über einen Datenträger eingelesen werden oder über Schnittstellen der Maschine zu CAD-Datenservern ausgewählt werden. Ausgangspunkt ist also ein geometrisches Volumenmodell des Spritzteils an sich, sodass das Ergebnis der Spritzgießprozess-Parametrierung im Wesentlichen von den spezifischen Geometrieinformationen über das Spritzteil abhängt. Weiterhin wird wenigstens ein schrittweises Volumenwachstumsprofil des Spritzteils aus den Geometrieinformationen berechnet, wobei für eine vorteilhaft schnelle und einfache Berechnung das Volumenwachstumsprofil des Spritzteils ausgehend von wenigstens einem Angusspunkt schichtweise berechnet wird, wobei jeder Schicht eine bestimmte Wegstrecke (Δs) eines Fördermittels oder ein bestimmtes Volumen (ΔV) zugeordnet wird. Der Angusspunkt kann vorzugsweise aus den dargestellten Geometriedaten an der Bedieneinheit der Spritzgeißmaschine interaktiv vom Bediener ausgewählt werden, alternativ parametrisch in den Geometriedaten hinterlegt sein oder durch eine Geometrieanalyse bei zusätzlich bekannter Werkzeuggeometrie berechnet werden. Das Spritzteil wird so, ähnlich zu einer z.B. additiven Fertigung, in Schichten aufgeteilt. Wird das jeweilige Volumen aller Schichten aufsummiert, ergibt sich das komplette Volumen des Spritzteils.

Unter Berücksichtigung des schrittweisen Volumenwachstumsprofils und der Annahme einer mit einer konstanten Geschwindigkeit fließenden Massefront wird ferner wenigstens ein Einspritzprozess berechnet. Dadurch wird eine vereinfachte, schnelle und effektive Parametrierung des Spritzgießprozesses an der Spritzgießmaschine ermöglicht, da kein spezielles Fachwissen beim Einrichten der Maschine benötigt wird. Der Bediener wird vielmehr in der Einrichtung unterstützt, sodass mögliche Fehlerquellen bereits zu Anfang des Spritzprozesses ausgeräumt werden und sich dadurch der Abmusterungsprozess zum einen wesentlich verkürzt, fehlerfreier bezüglich möglichen Unter- oder Überspritzungen wird und sich die Qualität des Spritzteils durch das der Geometrie angepasste Volumenwachstumsprofil verbessert. Gleichzeitig kann das zur Maschinenbedienung notwendige Expertenwissen reduziert werden.

Wesentlich für die Berechnung des schrittweisen Volumenwachstumsprofils ist, dass Informationen wenigstens über einen Teil der Informationen umfassend die Geometrie des Spritzteils und/oder des Formhohlraums sowie der Angussgeometrie bereitgestellt werden. Diese Informationen können dabei aus unterschiedlichen Quellen stammen. Beispielsweise aus einem CAD-Programm oder aus einem 3D-Scan. Prinzipiell denkbar ist auch, dass die Informationen bereits verfügbar sind, z.B. im Expertenwissen.

Unter Berücksichtigung der Geometrieinformationen wird im Anschluss wenigstens ein Volumenwachstumsprofil des Spritzteils berechnet. Dazu wird die Geometrie des Spritzteils in Füllrichtung in Bereiche aufgeteilt, welche zusammengenommen das komplette Volumen des Spritzteils ergeben. Jeder Bereich enthält somit ein entsprechendes Teilvolumen. Wird der Formhohlraum gefüllt, füllen sich nach und nach die Bereiche, wobei im Allgemeinen einmal ein größeres bzw. einmal ein kleineres Volumen mit Material gefüllt wird, bis alle Bereiche bzw. das komplette Volumen vollständig gefüllt sind. Durch diesen Verlauf wird ein Volumenwachstumsprofil berechnet.

Das Volumenwachstumsprofil wird im ersten Schritt mittels eines vorzugsweise konstanten virtuellen Digitalisierungsfüllvolumens berechnet. Auf dieser Basis ist dann der mögliche Folgeschritt z.B., dass das Volumenwachstumsprofil als eine Kurve des Volumens über der Zeit oder des Weges z.B. eines Fördermittels wie einer Förderschnecke dargestellt wird. Anhand des Volumenwachstumsprofils aus den Geometriedaten des Spritzteils lassen sich Einstelldaten hinsichtlich z.B. des Einspritzvolumens, der Wandstärken, der Fließverhältnisse, der Fließgeschwindigkeiten und der absoluten Fließwege ableiten.

Unter Berücksichtigung des Volumenwachstumsprofils wird im Anschluss wenigstens eine Sollwertparametrierung für eine Einspritzkurve der Spritzgießmaschine berechnet. Die so berechnete Füllkurve wird beispielsweise als Vorschlag dem Bediener an einer interaktiv bedienbaren Anzeige-/Bedienvorrichtung angezeigt.

Das Berechnen des schrittweisen Volumenwachstumsprofils des Spritzteils erfolgt vor der Durchführung eines ersten Einspritzprozesses zur Herstellung eines Spritzteils. Dadurch lassen sich mögliche Fehlerquellen zu Beginn des Spritzprozesses zuverlässig beseitigen und der Abmusterungsprozess weiter verkürzen. Gleichzeitig kann das zur Maschinenbedienung notwendige Expertenwissen noch stärker reduziert werden.

Das Volumenwachstumsprofil wird unter Berücksichtigung wenigstens einer der Informationen betreffend das Gesamtspritzvolumen oder dickste und dünnste Wandstärke des Spritzteils oder Wandstärkenverhältnisse oder Fließwegverhältnisse berechnet: Diese Informationen können vorzugsweise aus dem Expertenwissen entnehmbar sein. Anhand dieser in der Spritzgießtechnik bekannten Parameter kann schnell und für den Bediener leicht nachvollziehbar ein Volumenwachstumsprofil erstellt werden.

Ferner wird für eine vorteilhafte effiziente Berechnung die schichtweise Berechnung des Volumenwachstumsprofils jeweils mit einem gleichen Volumenschritt durchgeführt. Beispielsweise wird für jeden Schichtschritt aus den Geometriedaten des Spritzteils eine projizierte Fläche berechnet und bei bekanntem Volumenschritt wird durch Aufsummation der Flächen multipliziert mit dem Volumenschritt eine Funktion berechnet, woraus das Volumenwachstumsprofil berechnet wird.

Besonders bevorzugt werden zur Berechnung des Volumenwachstumsprofils Informationen aus dem Expertenwissen verwendet werden, die einklassifiziert sind, um einen schnelleren Zugriff auf die gewünschten Informationen zu erhalten. Das Einklassifizieren kann auch hier so erfolgen, dass es für den Bediener nachvollziehbar ist, er also auch interaktiv schnell auf zutreffende, ihn unterstützenden Informationen zugreifen kann. Zu diesen Kriterien gehören z.B. Werkzeugklassen für Spritzgießwerkzeuge, Füllzeiten beim Einspritzprozess zur Herstellung des Spritzteils, Fließweg-Wandstärken-Verhältnisse im Spritzteil, Werkstoffklassen oder auch Nachdruckhöhen, bezogen auf minimale und maximale Wandstärken am Spritzteil. Der Klassifizierer kann diese Einklassifizierung vorteilhafterweise auch interaktiv mit einem Bediener anhand dieser Kriterien vornehmen.

Grundsätzlich ist stets eine interaktive Bedienersteuerung von Vorteil, da das System dann z.B. bei Störungen, bei fehlenden Informationen oder auch dann, wenn sich ergibt, dass ein derartiges Volumenwachstumsprofil auf der jeweiligen Maschine nicht oder nicht so ausführbar ist, weiteren Input vom Bediener einfordern kann oder ihn auch über die ermittelten Ergebnisse informieren kann.

Hinsichtlich einer vorteilhaft hohen Genauigkeit bei gleichzeitiger schneller Berechnung wird das Volumenwachstumsprofil durch wenigstens ein Integrationsverfahren berechnet, beispielsweise mit einem numerischen Integrationsverfahren, wie z.B. der Trapezregel.

Für eine vorteilhaft einfache, intuitive Bedienung werden die eingelesenen Geometriedaten an der Anzeige-/Bedienvorrichtung dargestellt. In einem weiteren Schritt wird wenigstens ein Angusspunkt relativ zur Spritzgießachse festgelegt. Dies kann beispielsweise interaktiv durch den Bediener erfolgen, vorzugsweise jedoch erkennt die Maschinensteuerung diesen selbständig durch entsprechende Analyse der Geometriedaten, insbesondere bei vorhandener umhüllender Geometrie-Informationen des Formwerkzeugs, z.B. mittels der Suche nach nicht geschlossenen Hüllkörpern. Ferner werden Festlegungen zu Symmetrie-Charakteristika durchgeführt, wie beispielsweise ob ein Mehrkavitäten-System vorliegt, das eventuell mit einem Heißkanalsystem versorgt wird und/oder ob ein Angussverteilersystem mit Mehrfachangüssen vorliegt. Je nach dem wird vom Verfahren zuerst nur eine Kavität betrachtet und danach die weitere Anzahl der Kavitäten durch Summierung bzw. durch einen Offset berechnet. Bei Mehrfachangüssen wird z.B. jeder einzelne Angusspunkt bis zum Erreichen eines sich berührenden Volumens aus den verschiedenen Angusspunkten separat betrachtet und aufaddiert. Sobald sich die Massefronten berühren, erfolgt die weitere Betrachtung, als wäre nur ein Angusspunkt vorhanden. In Bezug auf eventuelle dynamische Druckverluste wird z.B. eine Querschnittsfläche aufaddiert. Diese Vorgehensweise vereinfacht die Rechenoperationen spart somit Zeit und macht die Bedienung direkter.

Vorteilhaft für eine effiziente Einstellung der Maschine sowie einer eventuellen Peripherie ist, dass der Maschinensteuerung Werkstoffinformationen des zu verarbeitenden Materials als Informationen vom Bediener vorgegeben werden und/oder vom Bediener aus einem Expertenwissen ausgewählt werden. Prinzipiell ist es denkbar, z.B. die Materialklasse oder das gewünschte exakte Material auszuwählen. Damit und mit Maschinenkomponentendaten wie z.B. Daten zum eingebauten Einspritzmodul/Schnecke, eventueller dazu vorhandener Plastifiziermodelle für verschiedene Schneckengeometrien aus z.B. dem Expertenwissen und/oder eventuellen Peripheriedaten können Einstelldaten z.B. für die Schneckendrehzahl, Staudruck und Temperatureinstellung für die Zylinderheizung und Werkzeugtemperierung abgeleitet werden.

Mit dem Volumenwachstumsprofil und den Werkstoffinformationen wird wenigstens ein Einspritzprozess berechnet. Mit Hilfe des Volumenwachstumsprofils ist bekannt, wieviel Volumen in welcher Zeit oder bei welchem Weg befüllt werden soll. Kombiniert man dies mit den Werkstoffinformationen, können vorteilhaft Einstelldaten z.B. bzgl. des Einspritzprofils, der Einspritzgeschwindigkeit, des Nachdruck und/oder der Nachdruckzeit berechnet werden.

Dabei wird die Soll-Parametrierung für die Einspritzkurve unter der Annahme einer mit einer konstanten Geschwindigkeit fließenden Massefront bestimmt.

Um vorteilhaft einen sicheren und effizienten Spritzgießprozess zu gewährleisten, wird die Einspritzkurve durch die Spritzgießeinheit begrenzende Parameter angepasst. Beispielsweise werden zunächst die maximalen Geschwindigkeiten der Maschine berücksichtigt und so gewählt, dass die Maschine nicht "überfahren" wird. Danach werden z.B. die Beschleunigungen der Maschine berücksichtigt, sodass die maximalen Beschleunigungen nicht überschritten werden. Weiterhin wird der Einspritzprozess mittels Analyse der minimalen und maximalen Fließweglängen, Wandstärkenverhältnisse und des gesamt Teilevolumens mittels Klassen-Ähnlichkeitsvergleich im Expertenwissen auf absolute physikalische Werte normiert, vorzugsweise z.B. an die für die Klasse typische absolute minimale oder maximale Füllzeit angepasst.

Weitere Vorteile ergeben sich aus den Unteransprüchen und der nachfolgenden Beschreibung eines bevorzugten Ausführungsbeispiels. Die in den Patentansprüchen einzeln aufgeführten Merkmale sind in technologisch sinnvoller Weise miteinander kombinierbar und können durch erläuternde Sachverhalte aus der Beschreibung und durch Details aus den Figuren ergänzt werden, wobei weitere Ausführungsvarianten der Erfindung aufgezeigt werden.

Im Folgenden wird die Erfindung anhand eines in den beigefügten Figuren dargestellten Ausführungsbeispiels näher erläutert. Es zeigen:
- Fig.1: eine schematische Darstellung einer Spritzgießmaschine und zugehöriger Maschinensteuerung mit einer Anzeige-/Bedienvorrichtung,
- Fig.2: ein Ablaufdiagramm für die Steuerung und Parametrierung der Maschine,
- Fig.3a: eine schematische Darstellung eines Spritzteils mit Anguss,
- Fig.3b: eine schematische Darstellung eines Spritzteils mit Anguss,
- Fig.4: die Anzeige-/Bedienvorrichtung mit Volumenwachstumsprofil und Parametereingabe.

### Beschreibung bevorzugter Ausführungsbeispiele

Die Erfindung wird jetzt beispielhaft unter Bezug auf die beigefügten Zeichnungen näher erläutert. Allerdings handelt es sich bei den Ausführungsbeispielen nur um Beispiele, die nicht das erfinderische Konzept auf eine bestimmte Anordnung beschränken sollen. Bevor die Erfindung im Detail beschrieben wird, ist darauf hinzuweisen, dass sie nicht auf die jeweiligen Bauteile der Vorrichtung sowie die jeweiligen Verfahrensschritte beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn zudem in der Beschreibung oder in den Ansprüchen die Einzahl oder unbestimmte Artikel verwendet werden, bezieht sich dies auch auf die Mehrzahl dieser Elemente, solange nicht der Gesamtzusammenhang eindeutig etwas Anderes deutlich macht.

Im Rahmen dieser Erfindung werden die folgenden Definitionen verwendet:
- Ein "Volumenwachstumsprofil" beschreibt den Zuwachs an Volumen über die Zeit oder über den Weg eines Fördermittels.
- Ein "Einspritzprozess" ist der für die Herstellung eines bestimmten Spritzteils, dessen Geometriedaten für die Berechnung des Volumenwachstumsprofils zu Grunde lagen, erforderliche Prozess.
- Eine parametrierte "Einspritzkurve" ist ein durch mittels des Verfahrens berechnete Parameter bestimmter Einspritzprozess, der die Herstellung des bestimmten Spritzteils mit der Maschinensteuerung auf der jeweiligen Spritzgießmaschine gestattet.

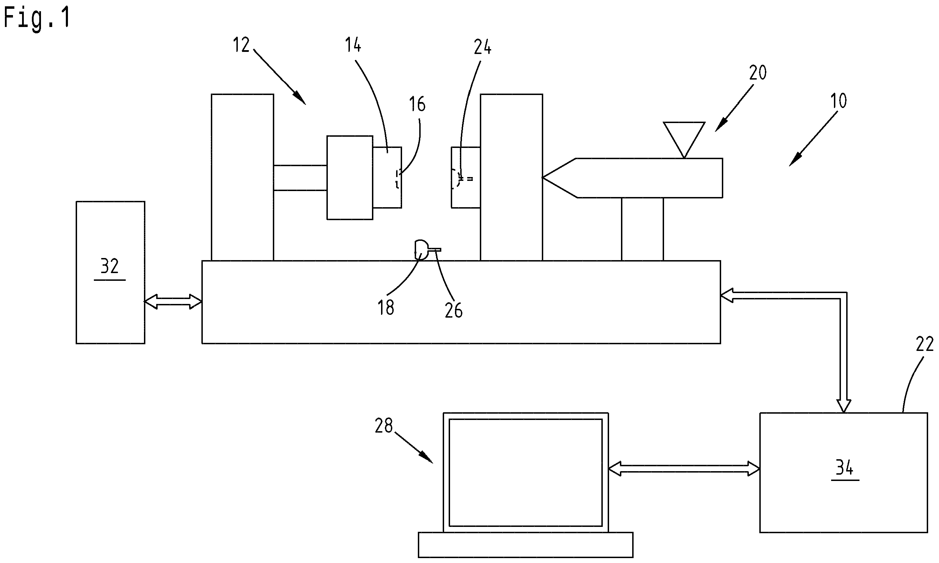

Fig. 1 zeigt eine schematische Darstellung einer Maschine 10 zur Verarbeitung von Kunststoffen und anderen plastifizierbaren Massen wie keramischen oder pulverigen Massen. Die Maschine 10 weist eine Formöffnungs- und -schließeinheit 12 zum Öffnen und Schließen einer Spritzgießform 14 mit wenigstens einem Formhohlraum 16 zur Herstellung eines der Form des Formhohlraumes 16 entsprechenden Spritzteils 18 sowie eine Spritzgießeinheit 20 auf. In Fig. 1 ist die Spritzgießform 14 geöffnet dargestellt und das Spritzteil 18 wurde ggf. mit seinem Anguss 26 aus dem Formhohlraum 16 ausgestoßen. Über eine Angussgeometrie 24 wird plastifizierbares Material in den Formhohlraum 16 zugeführt. Eventuelle Peripherie 32, z.B. Kühleinrichtungen oder Entnahmeeinrichtungen sind mit der Maschine 10 und/oder der Maschinensteuerung 22 verbunden.

Der Maschine 10 ist eine Maschinensteuerung 22 zugeordnet, welche mit einem Expertenwissen 34 in Form von beispielsweise Datenbanken über z.B. Netzwerke verbunden ist.

Das Expertenwissen 34 weist z.B. Daten bzgl. zu verarbeitender Werkstoffe, wie z.B. die spezifische Dichte des festen und flüssigen Materials, die Schmelztemperatur, den Fließindex, die maximale Scherrate und/oder allgemein das Druck-Temperatur-Verhalten beim Abkühlen der Materialien von flüssig nach fest, Daten bzgl. Spritzgießwissen über charakteristische Prozessverläufe, wie z.B. Daten zur Füllzeit für bestimmte Werkzeugklassen in Zusammenhang mit Fließweg-Wandstärken-Verhältnissen im Spritzteil gekoppelt mit bestimmten Werkstoffklassen sowie Nachdruckhöhen bezogen auf minimale und maximale Wandstärken am Spritzteil und/oder Daten zu den statischen und dynamischen Eigenschaften der Maschinenkinematik auf. Prinzipiell denkbar sind jedoch auch andere Daten im Expertenwissen 34, die zur Beschreibung eines Spritzgießprozesses, der dazugehörigen Ausrüstung und/oder Materialen dienen können. Prinzipiell denkbar ist auch, dass das Expertenwissen 34 in der Maschinensteuerung 22 selbst vorhanden ist.

Für den interaktiven Kontakt zwischen der Maschinensteuerung 22 und dem Bediener ist eine Anzeige-/Bedienvorrichtung 28 vorgesehen, welche beispielsweise durch einen Bildschirm mit Tastatur, einen (Multi)Touchscreen oder auch andere geeignete Mittel, wie z.B. Spracheingabe, zur Verfügung gestellt wird.

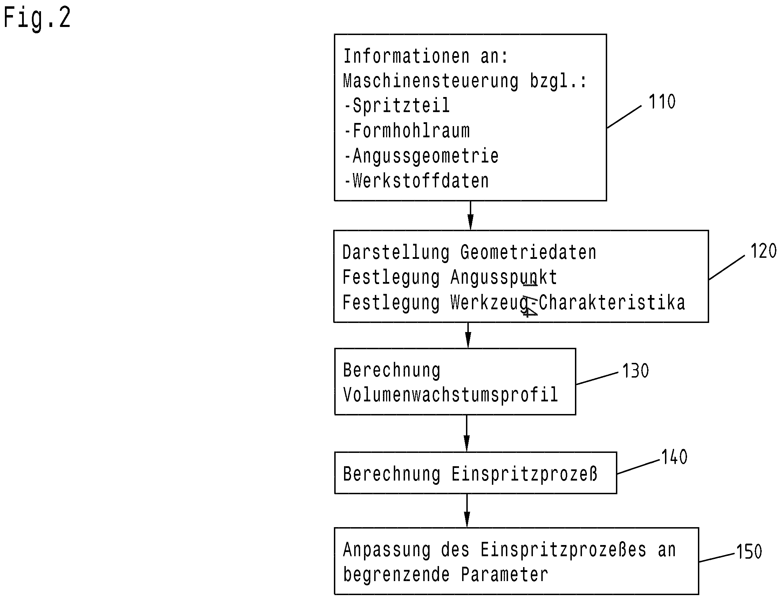

Fig. 2 zeigt den Ablauf des Verfahrens. Zu Beginn des Verfahrens erhält die Maschinensteuerung 22 im Schritt 110 Informationen über die Geometrie des Spritzteils 18 und dessen Anordnung als Formhohlraum 16 im Werkzeug und der Angussgeometrie 24. Die Geometriedaten können aus unterschiedlichsten Quellen stammen, beispielsweise aus einem CAD-Programm oder von einem 3D-Scan von einem z.B. vorher gedruckten 3D-Prototyp. Prinzipiell denkbar ist auch, dass das Expertenwissen 34 bereits Geometriedaten enthält und/oder diese dort gespeichert bzw. speicherbar sind.

Vorzugsweise werden in einem weiteren Ausführungsbeispiel in Schritt 110 Werkstoffdaten des zu verarbeitenden Materials bereitgestellt, welche beispielsweise vom Bediener vorgegeben oder aus dem Expertenwissen 34 ausgewählt werden. Beispielsweise erfolgt eine Auswahl einer Materialklasse oder des exakten Materials aus einer Materialdatenbank des Expertenwissens 34. Die Maschinensteuerung 22 berechnet damit und mit Maschinenkomponentendaten wie z.B. eingebautes Einspritz- und Plastifiziermodul/Schnecke, eventueller dazu vorhandener Plastifiziermodelle für verschiedene Schneckengeometrien sowie mit eventuellen Daten der Peripherie 32 Einstellwerte der Maschine 10, wie z.B. die Schneckendrehzahl, Staudruck und Temperatureinstellung für die Zylinderheizung und Werkzeugtemperierung. Vorzugsweise werden in Schritt 120 die Geometriedaten des Spritzteils 18 an der Anzeige-/Bedienvorrichtung 28 dargestellt. Durch den Bediener kann dadurch einfach und intuitiv wenigstens einen Angusspunkt relativ zur Spritzgießachse festgelegt werden. Prinzipiell denkbar ist auch, dass die Maschinensteuerung 22 einen Vorschlag für den Angusspunkt errechnet z.B. mittels der Kenntnis der geometrischen Beziehung des Kavitätensystems zum Werkzeug. Weitere interaktive Operationen durch den Bediener sind vorzugsweise Festlegungen zu Werkzeug-Charakteristika, wie z.B. ob ein Mehrkavitäten-Werkzeug mit Heißkanalsystem oder ein Werkzeug mit Mehrfachangüssen vorliegt. Je nach dem betrachtet das Verfahren zuerst nur eine Kavität und berechnet danach die weitere Anzahl Kavitäten durch einfache Summierung bzw. durch einen Offset. Bei Mehrfachangüssen wird jeder einzelne Angusspunkt bis zum Erreichen eines sich berührenden Volumens aus den verschiedenen Angusspunkten separat betrachtet und aufaddiert. Sobald sich die Massefronten berühren, erfolgt die weitere Betrachtung, als wäre nur ein Angusspunkt vorhanden. In Bezug auf eventuelle dynamische Druckverluste wird z.B. eine Querschnittsfläche aufaddiert.

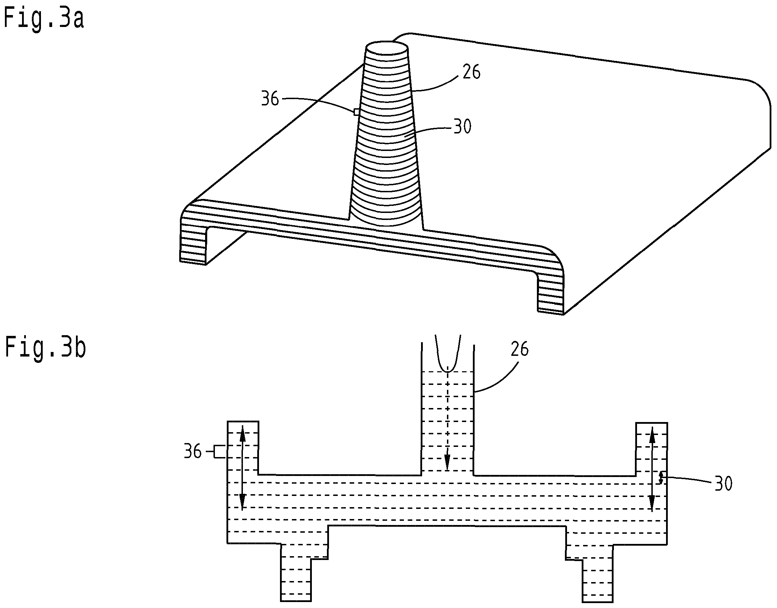

Die Berechnung des Volumenwachstumsprofils erfolgt in Schritt 130. In Fig. 3a und 3b sind Geometrien von Spritzteilen 18 schematisch dargestellt. Mit Hilfe der Geometriedaten des Spritzteils 18 wird, beginnend von einem Angusspunkt, das Volumenwachstumsprofil schichtweise berechnet. Die Geometrie des Spritzteils 18 wird schichtweise bzw. schrittweise aufgebaut. Beispielsweise baut sich in Fig. 3a beginnend vom Angusspunkt das Volumen des Spritzteils 18 in Schichten 36 bis zum Spritzteilgrund auf. Danach folgt der Aufbau radial zum Anguss 26. In Fig. 3b werden beginnend vom Anguss 26 beide Seiten, rechts und links vom Anguss 26 aus, gleichmäßig aufgebaut.

Die Berechnung des schrittweisen Volumenwachstumsprofils des Spritzteils wird vor der Durchführung eines ersten Einspritzprozesses zur Herstellung eines Spritzteils durchgeführt. Dadurch lassen sich mögliche Fehlerquellen zu Beginn des Spritzprozesses zuverlässig beseitigen und der Abmusterungsprozess weiter verkürzen. Gleichzeitig kann das zur Maschinenbedienung notwendige Expertenwissen noch stärker reduziert werden.

Zur Erstellung des Volumenwachstumsprofils werden Informationen genutzt, die das Gesamtspritzvolumen oder dickste und dünnste Wandstärke des Spritzteils oder Wandstärkenverhältnisse oder Fließwegverhältnisse umfassen, und die vorzugsweise aus dem Expertenwissen entnehmbar sind.

In Schritt 140 wird unter Berücksichtigung des schrittweisen Volumenwachstumsprofils und der Annahme einer mit einer konstanten Geschwindigkeit fließenden Massefront wenigstens ein Einspritzprozess berechnet.

Vorzugsweise wird die schichtweise Berechnung des Volumenwachstumsprofils jeweils mit einem gleichen Volumenschritt 30 gemäß Fig. 3a und 3b durchgeführt.

Weiter bevorzugt wird das Volumenwachstumsprofil durch wenigstens ein Integrationsverfahren berechnet, wie beispielsweise durch ein numerisches Integrationsverfahren z.B. mittels der Trapezregel.

Um die Berechnung des Volumenwachstumsprofils nachvollziehbar zu machen und ggf. zu beschleunigen kann ein Klassifizierer genutzt werden, der Informationen aus dem Expertenwissen und/oder Informationen, die vom Bediener vorgegeben werden, verwendet und klassifiziert. Diese Informationen können z.B. nach wenigstens einem der folgenden Kriterien nach Klassen eingeordnet und unterschieden werden: Werkzeugklassen für Spritzgießwerkzeuge,
- Füllzeitklassen beim Einspritzprozess zur Herstellung des Spritzteils 18,
- Fließweg-Wandstärken-Verhältnisse im Spritzteil 18,
- Werkstoffklassen,
- Nachdruckhöhen, bezogen auf minimale und maximale Wandstärken am Spritzteil 18.

Der Klassifizierer nimmt, vorzugsweise interaktiv mit einem Bediener, eine Einklassifizierung des Spritzteils 18 anhand dieser Kriterien vor, um zutreffende Informationen aus dem Expertenwissen zur Berechnung zugänglich zu machen.

Um nur einige nicht beschränkende Beispiele zu nennen, können Auswahlklassen so z.B. verschiedene Wandstärken, Fließverhältnisse z.B. größer 200 oder maximale Füllzeiten, z.B. kleiner 0,2 s sein.

Vorzugsweise erfolgt die Berechnung des Volumenwachstumsprofils des Spritzteils 18 vorzugsweise ausgehend von wenigstens einem Angusspunkt schichtweise, wobei jeder Schicht 36 eine bestimmte Wegstrecke Δs eines Fördermittels wie einer Förderschnecke oder ein bestimmtes Volumen ΔV zugeordnet wird.

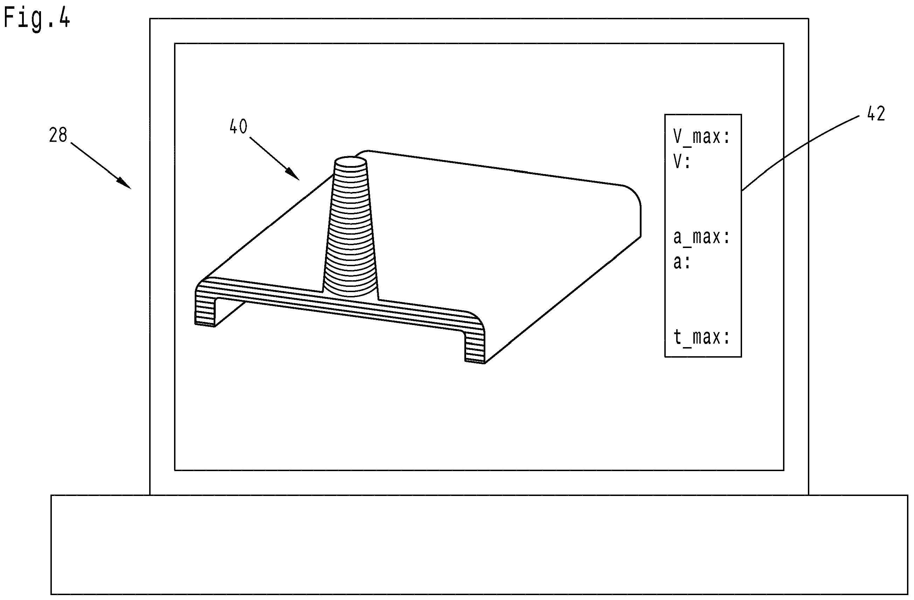

In einem weiteren bevorzugten Ausführungsbeispiel wird in Schritt 150 der Einspritzprozess durch die Spritzgießeinheit 20 begrenzende Parameter 42 angepasst, wie beispielsweise maximale Geschwindigkeiten und/oder Beschleunigungen, mit der die Maschine 10 gefahren werden kann, so dass die Maschine 10 nicht "überfahren" wird. Ferner wird die minimal/maximal gewünschte Füllzeit mittels einer z.B. quadratischen oder sinusförmigen Interpolation der der Maschine möglichen Geschwindigkeitswerte in einem z.B. rekursiven Verfahren angepasst. Die Anpassungen der Parameter 42 können beispielsweise gemäß Fig. 4 an der Anzeige-/Bedienvorrichtung 28 vom Bediener vorgenommen werden.

Grundsätzlich ist stets eine interaktive Bedienersteuerung von Vorteil, da das System dann z.B. bei Störungen, bei fehlenden Informationen oder auch dann, wenn sich ergibt, dass ein derartiges Volumenwachstumsprofil auf der jeweiligen Maschine nicht oder nicht so ausführbar ist, weiteren Input vom Bediener einfordern kann oder ihn auch über die ermittelten Ergebnisse informieren kann. Ebenso kann der Bediener geführt Eingreifen, z.B. um Anguss oder Fließrichtung zu identifizieren.

### Bezugszeichenliste

- 10: Maschine
- 12: Formöffnungs- und -schließeinheit
- 14: Spritzgießform
- 16: Formhohlraum
- 18: Spritzteil
- 20: Spritzgießeinheit
- 22: Maschinensteuerung
- 24: Angussgeometrie
- 26: Anguss
- 28: Anzeige-/Bedienvorrichtung
- 30: Volumenschritt
- 32: Peripherie
- 34: Expertenwissen
- 36: Schicht
- 40: Klassifizierer
- 42: Parameter

## Patentansprüche

1. Verfahren zur Steuerung einer Maschine (10) zur Verarbeitung von Kunststoffen und anderer plastifizierbarer Materialien wie pulverförmige und/oder keramische Massen, wobei die Maschine aufweist,
- eine Formöffnungs- und -schließeinheit (12) zum Öffnen und Schließen einer Spritzgießform (14) mit wenigstens einem Formhohlraum (16) zur Herstellung eines der Form des Formhohlraumes (16) entsprechenden Spritzteils (18),
- eine Spritzgießeinheit (20) mit Mitteln zum Plastifizieren und zum Einspritzen des plastifizierbaren Materials in den Formhohlraum (16),
- eine Maschinensteuerung (22), die mit einem Expertenwissen (34) verbunden ist und bedarfsweise interaktiv vom Bediener beeinflussbar ist,
wobei das Verfahren die Schritte aufweist:
- Bereitstellen von Informationen über die Geometrie des Spritzteils (18) und/oder des das Spritzteil aufnehmenden Formhohlraumes (16) an die Maschinensteuerung (22),
- Bereitstellen von Informationen über die Angussgeometrie (24) an die Maschinensteuerung (22),
- Berechnen wenigstens eines schrittweisen Volumenwachstumsprofils des Spritzteils (18) in Füllrichtung des Formhohlraums (16) unter Berücksichtigung der Geometrieinformationen, wobei das Volumenwachstumsprofil des Spritzteils (18) ausgehend von wenigstens einem Angusspunkt schichtweise berechnet wird, wobei jeder Schicht eine bestimmte Wegstrecke (Δs) eines Fördermittels oder ein bestimmtes Volumen (ΔV) zugeordnet wird, wobei
- das Berechnen des wenigstens einen schrittweisen Volumenwachstumsprofils des Spritzteils (18) vor der Durchführung eines ersten Einspritzprozesses zur Herstellung eines Spritzteils erfolgt, wobei
- das Volumenwachstumsprofil unter Berücksichtigung wenigstens einer der Informationen betreffend das Gesamtspritzvolumen oder dickste und dünnste Wandstärke des Spritzteils oder Wandstärkenverhältnisse oder Fließwegverhältnisse berechnet wird, die vorzugsweise aus dem Expertenwissen entnehmbar sind, und wobei
- wenigstens ein Einspritzprozess unter Berücksichtigung des schrittweisen Volumenwachstumsprofils und der Annahme einer mit einer konstanten Geschwindigkeit fließenden Massefront berechnet wird.

2. Verfahren nach Anspruch 1, **dadurch gekennzeichnet, dass** das Berechnen des Volumenwachstumsprofils jeweils mit einem gleichen Volumenschritt (30) durchgeführt wird.

3. Verfahren nach Anspruch 1 oder 2, **dadurch gekennzeichnet, dass** zur Berechnung des Volumenwachstumsprofils Informationen aus dem Expertenwissen verwendet werden, die nach wenigstens einem der folgenden Kriterien nach Klassen eingeordnet und unterscheidbar sind, umfassend
- Werkzeugklassen für Spritzgießwerkzeuge,
- Füllzeitklassen beim Einspritzprozess zur Herstellung des Spritzteils (18),
- Fließweg-Wandstärken-Verhältnisse im Spritzteil (18),
- Werkstoffklassen,
- Nachdruckhöhen, bezogen auf minimale und maximale Wandstärken am Spritzteil (18),
wobei ein Klassifizierer, vorzugsweise interaktiv mit einem Bediener, eine Einklassifizierung des Spritzteils (18) anhand dieser Kriterien vornimmt, um zutreffende Informationen aus dem Expertenwissen zur Berechnung zugänglich zu machen.

4. Verfahren nach einem der vorhergehenden Ansprüche, **dadurch gekennzeichnet, dass** das Volumenwachstumsprofil durch wenigstens ein Integrationsverfahren berechnet wird.

5. Verfahren nach einem der vorhergehenden Ansprüche, **gekennzeichnet durch** wenigstens einen der Schritte:
- Darstellen der Geometriedaten an einer Anzeige-/Bedienvorrichtung (28),
- Festlegen wenigstens eines Angusspunktes relativ zur Spritzgießachse vorzugsweise an Hand der Darstellung,
- Festlegen von Werkzeug-Charakteristika.

6. Verfahren nach einem der vorhergehenden Ansprüche, **dadurch gekennzeichnet, dass** der Maschinensteuerung (22) als weitere Informationen Werkstoffinformationen des zu verarbeitenden Materials vom Bediener vorgegeben werden und/oder als Informationen aus dem Expertenwissen (34) ausgewählt werden, die zur Normierung des Volumenwachstumsprofils verwendet werden und dass der wenigstens eine Einspritzprozess unter Berücksichtigung der Werkstoffinformationen berechnet wird.

7. Verfahren nach einem der vorhergehenden Ansprüche, **dadurch gekennzeichnet, dass** wenigstens eine Soll-Parametrierung für die Einspritzkurve unter der Annahme einer mit einer möglichst konstanten Fließfront-Geschwindigkeit, vorzugsweise einer konstanten Volumenwachstumsgeschwindigkeit, fließenden Massefront bestimmt wird.

8. Verfahren nach einem der vorhergehenden Ansprüche, **dadurch gekennzeichnet, dass** eine Soll-Parametrierung für die Einspritzkurve durch die Spritzgießeinheit (20) begrenzende Parameter (42) angepasst wird.

## Claims

1. A method for controlling a machine (10) for processing plastics and other plasticisable materials such as powder and/or ceramic materials, wherein the machine comprises
- a mould opening and closing unit (12), for opening and closing an injection mould (14) comprising at least one mould cavity (16) for manufacturing a moulding (18) that corresponds to the shape of the mould cavity (16),
- an injection moulding unit (20) having devices for plasticising and for injecting the plasticisable material into the mould cavity (16),
- a machine controller (22) that is in communication with an expert knowledge unit (34) and where necessary is configured to be interactively influenced by the operating person,
wherein the method comprises the steps of:
- providing information, on the geometry of the moulding (18) and/or the mould cavity (16) that receives the moulding, to the machine controller (22),
- providing information on the sprue geometry (24) to the machine controller (22),
- calculating at least one step-by-step volume growth profile of the moulding (18) in the direction of filling the mould cavity (16), taking into account the geometric information, wherein the volume growth profile of the moulding (18) is calculated layer by layer, beginning from at least one sprue point, wherein a particular distance (Δs) covered by a conveying device, or a particular volume (ΔV), is associated with each layer,
- wherein the calculation of the at least one step-by-step volume growth profile of the moulding (18) is performed before a first injection procedure for manufacture of a moulding is carried out,
- wherein the volume growth profile is calculated taking into account at least one of the items of information in respect of the total injection volume or the thickest and thinnest wall thickness of the moulding or the wall thickness ratios or flow path ratios, wherein this information is preferably to be found in the expert knowledge unit, and
- wherein at least one injection procedure is calculated, taking into account the step-by-step volume growth profile and on the assumption of a material front that flows at constant speed.

2. A method according to Claim 1, **characterised in that** the calculation of the volume growth profile is carried out with the same volume step (30) each time.

3. A method according to Claim 1 or 2, **characterised in that** for the purpose of calculating the volume growth profile information from the expert knowledge unit is used, this information being categorised into classes and distinguishable by at least one of the following criteria:
- mould classes for injection moulds,
- filling time classes during the injection procedure for manufacturing the moulding (18),
- flow path/wall thickness ratios in the moulding (18),
- material classes,
- holding pressures in relation to minimum and maximum wall thicknesses in the moulding (18),
wherein a classifier, preferably interactively with an operating person, classifies the moulding (18) on the basis of these criteria in order to make relevant information from the expert knowledge unit accessible for the purpose of calculation.

4. A method according to one of the preceding claims, **characterised in that** the volume growth profile is calculated by at least one integration method.

5. A method according to one of the preceding claims, **characterised by** at least one of the steps of:
- displaying the geometric data at a display/operating device (28),
- identifying at least one sprue point in relation to the axis of injection, preferably with reference to the display,
- identifying mould characteristics.

6. A method according to one of the preceding claims, **characterised in that** material information on the material to be processed is provided to the machine controller (22) as further information, predetermined by the operating person and/or selected as information from the expert knowledge unit (34), and is used for standardising the volume growth profile, and **in that** the at least one injection procedure is calculated taking into account the material information.

7. A method according to one of the preceding claims, **characterised in that** at least one setpoint parameterisation for the injection curve is determined on the assumption of a material front that flows at a flow front speed that is as constant as possible, preferably at a constant volume growth rate.

8. A method according to one of the preceding claims, **characterised in that** a setpoint parameterisation for the injection curve is adapted to parameters (42) delimiting the injection moulding unit (20).

## Revendications

1. Procédé de commande d'une machine (10) pour la fabrication de matières plastiques et d'autres matériaux plastifiables comme des masses pulvérulentes et/ou céramiques, cette machine comprenant,
- une unité d'ouverture et de fermeture de moule (12) pour l'ouverture et la fermeture d'un moule pour moulage par injection (14) comportant au moins un espace creux pour moule (16) pour la fabrication d'une pièce moulée par injection (18) correspondant à la forme de l'espace creux pour moule (16),
- une unité de moulage par injection (20) avec des moyens pour plastifier et pour injecter le matériau plastifiable dans l'espace creux pour moule (16),
- une commande de machine (22), qui peut être reliée à des connaissances d'expert (34) et qui est influençable au besoin de manière interactive par l'utilisateur,
ce procédé comportant les étapes
- de mise à disposition de la commande de machine (22) d'informations sur la géométrie de la pièce moulée par injection (18) et/ou de l'espace creux pour moule (16) recevant la pièce moulée par injection,
- de mise à disposition de la commande de machine (22) d'informations sur la géométrie angulaire (24),
- de calcul d'au moins un profil de croissance de volume graduel de la pièce moulée par injection (18) dans la direction de remplissage de l'espace creux pour moule (16) en prenant en compte les informations de géométrie, le profil de croissance du volume de la pièce moulée par injection (18) étant calculé couche par couche à partir d'au moins un point angulaire, un tronçon déterminé (Δs) d'un moyen d'alimentation ou un volume déterminé (ΔV) étant associé à chaque couche,
dans lequel
- le calcul du ou des profil(s) de croissance de volume graduel(s) de la pièce moulée par injection (18) ayant lieu avant la réalisation d'une première opération d'injection pour la fabrication d'une pièce moulée par injection, dans lequel
- le profil de croissance de volume est calculé en prenant en compte au moins l'une des informations concernant le volume d'injection total ou l'épaisseur de paroi la plus grosse ou la plus mince de la pièce moulée par injection ou des rapports d'épaisseur de paroi ou des rapports de trajectoire d'écoulement, qui peuvent de préférence être déduits des connaissances d'expert, et dans lequel
- au moins une opération d'injection est calculée en prenant en compte le profil de croissance de volume graduel et l'hypothèse d'un front de masse s'écoulant à une vitesse constante.

2. Procédé selon la revendication 1, **caractérisé en ce que** le calcul du profil de croissance de volume est à chaque fois réalisé avec une même étape volumique (30).

3. Procédé selon la revendication 1 ou 2, **caractérisé en ce que** pour le calcul du profil de croissance de volume, des informations sont utilisées à partir des connaissances d'expert, lesquelles sont différentiables et rangées dans des classes suivant au moins l'un des critères suivants comprenant
- les classes d'outils pour les outils de moulage par injection,
- les classes de temps de remplissage lors de l'opération d'injection pour la fabrication de la pièce moulée par injection (18),
- les rapports trajectoire d'écoulement-épaisseurs de paroi dans la pièce moulée par injection (18),
- les classes de matériau,
- les hauteurs de réinjection, basées sur les épaisseurs de paroi minimales et maximales au niveau de la pièce moulée par injection (18),
dans lequel un classificateur, de préférence interactif avec un utilisateur, entreprend une classification de la pièce moulée par injection (18) sur la base de ces critères, afin de rendre accessibles au calcul des informations pertinentes à partir des connaissances d'expert.

4. Procédé selon l'une des revendications précédentes, **caractérisé en ce que** le profil de croissance de volume est calculé au moyen d'au moins une méthode d'intégration.

5. Procédé selon l'une des revendications précédentes, **caractérisé par** au moins l'une des étapes suivantes :
- représentation des données de géométrie sur un dispositif d'affichage/d'utilisation (28),
- définition d'au moins un point angulaire relatif à l'axe d'injection, de préférence à l'aide de la représentation,
- définition de caractéristiques d'outil.

6. Procédé selon l'une des revendications précédentes, **caractérisé en ce que** sont données préalablement par l'utilisateur à la commande de machine (22), en tant qu'informations supplémentaires, des informations sur le matériau à traiter et/ou sont choisies en tant qu'informations provenant des connaissances d'expert (34), ces informations étant utilisées pour la normalisation du profil de croissance de volume et **en ce que** la ou les opération(s) d'injection est/sont calculée(s) en prenant en compte les informations sur le matériau.

7. Procédé selon l'une des revendications précédentes, caractérisé en qu'au moins un paramétrage de consigne est déterminé pour la courbe d'injection avec l'hypothèse d'une vitesse de front d'écoulement si possible constante, de préférence d'un front de masse s'écoulant à vitesse de croissance de volume constante.

8. Procédé selon l'une des revendications précédentes, **caractérisé en ce qu'**un paramétrage de consigne est adapté à la courbe d'injection au moyen des paramètres (42) limitant l'unité de moulage par injection (20).
